Europäisches Patentamt

European Patent Office

Office européen des brevets

(19)

(11) **EP 1 526 672 A1**

(12) **EUROPEAN PATENT APPLICATION**

(43) Date of publication:
**27.04.2005 Bulletin 2005/17**

(51) Int Cl.⁷: **H04L 1/06**, H04L 25/03, H04B 7/06

(21) Application number: **04254557.4**

(22) Date of filing: **29.07.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **02.10.2003 GB 0323074**

(71) Applicant: **Toshiba Corporation Tokyo 105-8001 (JP)**

(72) Inventors:
• **Piechocki, Robert Jan Ferry Street, Bristol BS1 6HW (GB)**
• **Sandell, Magnus, Toshiba Research Europe Ltd Bristol BS1 4ND (GB)**
• **Parker, Steve C. J., Toshiba Research Europe Ltd Bristol BS1 4ND (GB)**
• **Andrieu, Christophe, Toshiba Research Europe Ltd. Bristol BS1 4ND (GB)**

(74) Representative: **Midgley, Jonathan Lee Marks & Clerk 90 Long Acre London WC2E 9RA (GB)**

(54) **Signal decoding method and apparatus**

(57) This invention is generally concerned with methods, apparatus and processor control code for decoding a signal received over a MIMO (multiple input - multiple output) channel.

A method of decoding a signal encoded as a string of symbols over space and time and/or frequency, transmitted over a MIMO (multiple-input multiple-output) channel, and received at a plurality of receive antennas, each transmitted symbol having one of a plurality of values, said decoding comprising determining a probability distribution for each symbol of the transmitted string of symbols; the method comprising: determining an initial estimate of said transmitted string of symbols from said received signal using an estimate of a response of said MIMO channel; and determining from said initial estimate a probability distribution for each symbol of the transmitted string of symbols, the probability distribution representing the likelihood of a symbol of the string having each of its possible values when other symbols of the transmitted string are treated as noise.

S200 COMPUTE ZERO-FORCING ESTIMATE OF TRANSMITTED SIGNAL

S202 INITIALISE SYMBOL PROBABILITIES

S204 COMPUTE EXPECTATION VALUE AND VARIANCE FOR EACH TRANSMITTED SYMBOL; INITIALISE m = 1

S206 FOR SYMBOL m COMPUTE NOISE MEAN AND AUTO-COVARIANCE AND PROBABILITY OF Xm = s GIVEN THE ZERO-FORCING ESTIMATE AND NOISE AND UPDATE SYMBOL EXPECTATION AND VARIANCE VALUES

S208 REPEAT UNTIL m = M

S210 ITERATE

S212 OPTIONALLY TEMPER PROBABILITY DISTRIBUTIONS

S214 SOFT DECODER OUTPUT

Figure 2

EP 1 526 672 A1

**Description**

This invention is generally concerned with methods, apparatus and processor control code for decoding a signal received over a MIMO (multiple input - multiple output) channel.

There is a continuing desire for increased data rate transmission. The current generation of WLAN (wireless local area network) standards such as Hiperlan/2 (in Europe) and IEEE802.11a (in the USA) provide data rates of up to 54 Mbit/s. Increased data rates, for example for multimedia services, may be achieved by simply increasing the data transmission bandwidth, but this is inefficient and expensive. MIMO systems have the capability to increase throughput without increasing bandwidth, the throughput potentially scaling linearly with the number of transmit/receive antennas, for example a four transmit, four receive antenna system potentially providing four times the capacity of a single transmit-receive antenna system. However receivers for MIMO communications systems are complex because a single receive antenna receives signals from all the transmit antennas, causing decoding difficulties.

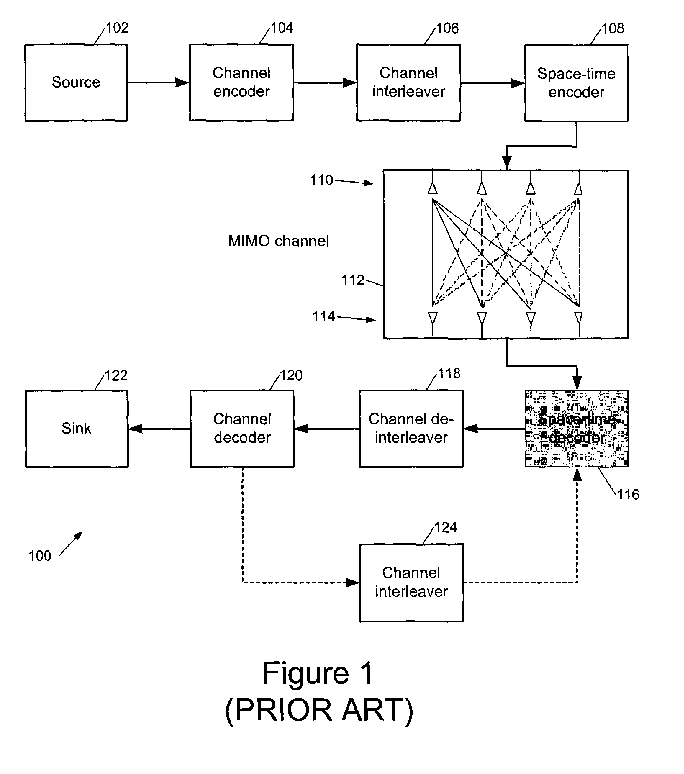

Figure 1 shows a typical MIMO data communications system 100. A data source 102 provides data (comprising information bits or symbols) to a channel encoder 104. The channel encoder typically comprises a convolutional coder such as a recursive systematic convolutional (RSC) encoder, or a stronger so-called turbo encoder (which includes an interleaver). More bits are output than are input, and typically the rate is one half or one third. The channel encoder 104 is followed by a channel interleaver 106 and, in the illustrated example, a space-time encoder 108. The space-time encoder 108 encodes an incoming symbol or symbols as a plurality of code symbols for simultaneous transmission from each of a plurality of transmit antennas 110.

Space-time encoding may be described in terms of an encoding machine, described by a coding matrix, which operates on the data to provide spatial and temporal transmit diversity; this may be followed by a modulator to provide coded symbols for transmission. Space-frequency encoding may additionally (or alternatively) be employed. Thus, broadly speaking, incoming symbols are distributed into a grid having space and time and/or frequency coordinates, for increased diversity. Where space-frequency coding is employed the separate frequency channels may be modulated onto OFDM (orthogonal frequency division multiplexed) carriers, a cyclic prefix generally being added to each transmitted symbol to mitigate the effects of channel dispersion.

The encoded transmitted signals propagate through MIMO channel 112 to receive antennas 114, which provide a plurality of inputs to a space-time (and/or frequency) decoder 116. This has the task of removing the effect of the encoder 108. The output of the decoder 116 comprises a plurality of signal streams, one for each transmit antenna, each carrying so-called soft or likelihood data on the probability of a transmitted symbol having a particular value. This data is provided to a channel de-interleaver 118 which reverses the effect of channel interleaver 106, and then to a channel decoder 120, such as a Viterbi decoder, which decodes the convolutional code. Typically channel decoder 120 is a SISO (soft-in soft-out) decoder, that is receiving symbol (or bit) likelihood data and providing similar likelihood data as an output rather than, say, data on which a hard decision has been made. The output of channel decoder 120 is provided to a data sink 122, for further processing of the data in any desired manner.

In some communications systems so-called turbo or iterative decoding is employed in which a soft output from channel decoder 120 is provided to a channel interleaver 124, corresponding to channel interleaver 106, which in turn provides soft (likelihood) data to decoder 116 for iterative space-time (and/or frequency) and channel decoding. (It will be appreciated that in such an arrangement channel decoder 120 provides complete transmitted symbols to decoder 116, that is for example including error check bits.)

It will be appreciated that in the above described communication system both the channel coding and the space-time coding provide time diversity and thus this diversity is subject to the law of diminishing returns in terms of the additional signal to noise ratio gain which can be achieved. Thus when considering the benefits provided by any particular space-time/frequency decoder these are best considered in the context of a system which includes channel encoding.

One of the hardest tasks in the communications system 100 is the decoding of the space-time (or frequency) block code (STBC), performed by decoder 116, as this involves trying to separate the transmitted symbols that are interfering with one another at the receiver. The optimal STBC decoder is the *a posteriori* probability (APP) decoder, which performs an exhaustive search of all possible transmitted symbols. Such a decoder considers every transmitted symbol constellation point for all the transmit antennas and calculates all possible received signals, comparing these to the actually received signal and selecting that (those) with the closest Euclidian distance as the most likely solution (s). However the number of combinations to consider is immense even for a small number of antennas, a modulation scheme such as 16 QAM (quadrature amplitude modulation), and a channel with a relatively short time dispersion, and the complexity of the approach grows exponentially with the data rate. Sub-optimal approaches are therefore of technical and commercial interest.

Common choices for space-time block decoding are linear estimators such as zero-forcing and minimum mean-squared error (MMSE) estimators, decision feedback approaches (block decision feedback equalizer, vertical BLAST (Bell labs LAyered Space Time) decoder) and state-space methods with limited searches such as a sphere decoder. Other background prior art relating to multi-user systems can be found in IEEE Communication Letters, Vol 5, No 9, September 2001 'Near-Optimal Multiuser Detection in Synchronous CDMA Using Probabilistic Data Association' J Luo, KR Pattipati, PK Willett and F Hasegawa; and IEEE Journal on Selected Areas in Communications, Vol 18, No 11, November 2000 'Iterative Receivers for Multiuser Space-Time Coding Systems' Ben Lu and Xiaodong Wang.

Optimal decoding using an APP decoder is very complex but the other techniques mentioned above perform poorly. In particular suboptimal decoders tend to provide inaccurate soft output information, which can degrade performance significantly in a channel coded system. There is therefore a need for decoding techniques which provide improved performance without the complexity of the APP approach.

According to a first aspect of the invention there is therefore provided a method of decoding a signal encoded as a string of symbols over space and time and/or frequency, transmitted over a MIMO (multiple-input multiple-output) channel, and received at a plurality of receive antennas, each transmitted symbol having one of a plurality of values, said decoding comprising determining a probability distribution for each symbol of the transmitted string of symbols; the method comprising: determining an initial estimate of said transmitted string of symbols from said received signal using an estimate of a response of said MIMO channel; and determining from said initial estimate a probability distribution for each symbol of the transmitted string of symbols, the probability distribution representing the likelihood of a symbol of the string having each of its possible values when other symbols of the transmitted string are treated as noise.

Broadly speaking in embodiments the approach is to determine an initial estimate of the transmitted symbols in order to locate the correct region of state space, and then to migrate or walk this initial estimate closer to the maximum likelihood solution (as some bits/symbols of the initial estimate are likely to be incorrect), by looking at each symbol in the string in turn and, in effect, applying a probabilistic filter. The initial estimate can conveniently be determined by the zero-forcing method, that is by effectively taking the received signal and multiplying it by the inverse of the MIMO channel estimate. This provides an initial, in effect linear, estimate but does not take into account probabilistic effects arising from constraint of the transmitted signal by selection of constellation points (symbol values).

This initial estimate can then be used to determine an improved estimate for each symbol in turn by considering all the other symbols (except for the one under consideration) as interference and modelling these as noise, for example Gaussian noise. More particularly this noise may be characterized by mean and (auto-)covariance values. This enables the calculation of the probability that a particular symbol in the string had, when transmitted, a particular symbol value, given the initial (zero-forcing) estimate. This in turn allows the computation of a probability distribution for each symbol of the string, the probability distribution describing the likelihood of a symbol assuming one of the permitted symbol values. Preferably the noise is recharacterized after each determining of a probability distribution for a symbol. Furthermore the method may be iterated to redetermine the probability distributions for symbols of the string after a first iteration from the initial estimate. The probability distribution of a symbol may also be employed to determine a probability distribution for a bit making up the symbol.

The method is general in that the string of symbols may be distributed in space and/or time and/or frequency, and so may be employed in space-time, space-frequency and/or space-time/frequency decoders. Broadly speaking, in embodiments the procedure iterates to determine (a probability for) each symbol in a sequence in turn under a constraint of consistency with neighbouring symbols (within the Gaussian noise modelling terms of the procedure). Thus it will be appreciated that the procedure may be used for single or multiple carrier systems.

As previously alluded to, symbols except that under consideration are considered as Gaussian noise but, in reality, these symbols are constrained by their own constellations so this Gaussian noise assumption is not completely accurate. The noise is also coloured. One result of this appears to be that the procedure can predict a transmitted symbol with greater certainty than is in fact justified - in effect the procedure is overly optimistic. However providing a bit or symbol probability distribution with a probability spike at a particular value to a channel decoder can trap the decoder into a local maximum/minimum from which the channel decoder can find it difficult to escape. Paradoxically this can be a particular problem with high signal-to-noise ratios and with large numbers of antennas this effect is expected to be lessened. Nonetheless the method preferably includes tempering a probability distribution (for bit or symbol values) associated with a symbol to restrict the maximum certainty or increase the uncertainty in the value of the symbol predicted by the distribution. In effect, highly peaked distributions are flattened or spread to reduce the certainty of a prediction. Not all of the probability distributions need to be modified in this way, only those with, say, a spiked distribution of bit/symbol likelihood values. The tempering may comprise, for example, adjusting one or more probability distributions of one or more bits of a symbol.

Thus the invention further provides a method of decoding a signal encoded as a string of symbols over space and time and/or frequency, transmitted over a MIMO (multiple-input multiple-output) channel, and received at a plurality of receive antennas, each transmitted symbol having one of a plurality of values, said decoding comprising determining a probability distribution for each symbol of the transmitted string of symbols; the method comprising: determining a probability distribution for each symbol of the transmitted string of symbols, the probability distribution representing the likelihood of a symbol of the string having each of its possible values; and tempering a said symbol probability distribution or a probability distribution derived therefrom to increase the uncertainty in the value of a symbol associated with the distribution.

It will be appreciated that the above described methods may be employed, for example, in a turbo decoder, with iterative block code decoding and channel decoding.

The invention further provides decoders configured to implement the above-described methods, and receivers including such decoders.

Thus the invention further provides a decoder for decoding a signal encoded as a string of symbols over space and time and/or frequency, transmitted over a MIMO (multiple-input multiple-output) channel, and received at a plurality of receive antennas, each transmitted symbol having one of a plurality of values, said decoding comprising determining a probability distribution for each symbol of the transmitted string of symbols, said decoder comprising: means for determining an initial estimate of said transmitted string of symbols from said received signal using an estimate of a response of said MIMO channel; and means for determining from said initial estimate a probability distribution for each symbol of the transmitted string of symbols, the probability distribution representing the likelihood of a symbol of the string having each of its possible values when other symbols of the transmitted string are treated as noise.

In another aspect the invention provides a space-time block decoder for decoding a string of transmitted symbols received over a MIMO channel, the decoder comprising: a symbol estimator to determine an initial estimate of said transmitted symbols; a noise modeller to determine a noise estimate for each transmitted symbol; and a probability distribution estimator to determine a probability distribution for each of said transmitted symbols; and wherein: said noise modeller is responsive to said symbol estimator; said probability distribution estimator is responsive to said noise estimator; and said noise estimator is responsive to said probability distribution estimator.

The space-time block decoder may further include a MIMO channel estimator and/or a probability distribution adjuster or temperer to adjust an output of the probability distribution estimator to reduce a predicted probability along similar lines to those mentioned above. Again the decoder may be incorporated in a turbo decoder. A receiver including the decoder may also be provided.

The skilled person will recognise that the above-described methods and decoders may be implemented using and/or embodied in processor control code. Thus in a further aspect the invention provides such code, for example on a carrier medium such as a disk, CD- or DVD-ROM, programmed memory such as read-only memory (Firmware) or on a data carrier such as an optical or electrical signal carrier. Embodiments of the invention may be implemented on a DSP (Digital Signal Processor), ASIC (Application Specific Integrated Circuit) or FPGA (Field Programmable Gate Array). Thus the code may comprise conventional program code, or micro-code, or, for example, code for setting up or controlling an ASIC or FPGA. In some embodiments the code may comprise code for a hardware description language such as Verilog (Trade Mark) or VHDL (Very high speed integrated circuit Hardware Description Language). As the skilled person will appreciate, processor control code for embodiments of the invention may be distributed between a plurality of coupled components in communication with one another.

These and other aspects of the invention will now be further described, by way of example only, with reference to the accompanying figures in which:

Figure 1 shows an example of a MIMO space-time coded communications system;

Figure 2 shows a flow diagram of an embodiment of a decoding procedure according to an aspect of the present invention;

Figure 3 shows a receiver incorporating a decoder configured to operate in accordance with an embodiment of the present invention;

Figure 4 shows an example of probability distribution function tempering;

Figure 5 shows bit error rate against received signal to noise ratio, comparing an embodiment of a decoder according to the present invention with known decoding procedures; and

Figure 6 shows bit error rate against received signal to noise ratio for embodiments of the invention with and without probability distribution function tempering.

A system model for a STBC communication system with $M$ transmitting and $N$ receiving antennas can be written as $r = Hx + v$, where $r$ is the received signal (size $N$ x $1$), $H$ is the channel (impulse response) matrix (size $N$ x $M$), $x$ is the transmitted signal (size $M$ x $1$) and $v$ is the noise (size $N$ x $1$). We assume that each element of $x$ belongs to a constellation $S$, consisting of $Q$ symbols.

The first step is to calculate the so-called zero-forcing (ZF) estimate:

$$\overset{\wedge}{x}_{ZF} = (H^H H)^{-1} H^H r = x + (H^H H)^{-1} H^H v \qquad \text{(Equation 1)}$$

Assuming that the noise **v** is white, $E\{vv^H\} = N_0 I$, the coloured noise in $\overset{\wedge}{\mathbf{x}}_{ZF}$ can be written as

$$\widetilde{\mathbf{v}} = \left(\mathbf{H}^H \mathbf{H}\right)^{-1} \mathbf{H}^H \mathbf{v}$$
$$\mathbf{R}_{\widetilde{v}\widetilde{v}} = E\left\{\widetilde{\mathbf{v}}\widetilde{\mathbf{v}}^H\right\} = N_0 \left(\mathbf{H}^H \mathbf{H}\right)^{-1} \qquad \text{(Equation 2)}$$

We can now further enhance the estimate of **x** by considering one symbol at a time:

$$\hat{\mathbf{x}}_{ZF} = x_m \mathbf{e}_m + \sum_{k \neq m} x_k \mathbf{e}_k + \widetilde{\mathbf{v}} = x_m \mathbf{e}_m + \mathbf{w}_m$$

where $x_m$, is the m:th symbol in **x**, m labelling the transmit antennas and where $\mathbf{e}_m$ is the m:th unit vector (all zeros with a one in the m:th position).

By considering all symbols except the m:th as interference, we can model $\mathbf{w}_m$ as Gaussian noise with mean

$$\boldsymbol{\mu}_m = E\{\mathbf{w}_m\} = \sum_{k \neq m} E\{x_k\}\mathbf{e}_k \qquad \text{(Equation 3)}$$

and auto-covariance

$$\mathbf{R}_m = E\left\{(\mathbf{w}_m - \boldsymbol{\mu}_m)(\mathbf{w}_m - \boldsymbol{\mu}_m)^H\right\} = \sum_{k \neq m} E\left\{\left|x_k - E\{x_k\}\right|^2\right\} \mathbf{e}_k \mathbf{e}_k^H + \mathbf{R}_{\widetilde{v}\widetilde{v}} \qquad \text{(Equation 4)}$$

where

$$E\left\{\left|x_k - E\{x_k\}\right|^2\right\}$$

is the variance $Var\{x_k\}$ of $x_k$. We wish to compute $\Pr(x_m = s|\overset{\wedge}{\mathbf{x}}_{ZF},\mu_m, \mathbf{R}_m)$, that is the probability that $x_m$ assumes a certain symbol value s, given the zero-forcing estimate (and based upon the modelled noise from the interfering symbols). Since $\mathbf{w}_m$ is assumed to be Gaussian, we can write $\Pr(x_m = s|\overset{\wedge}{\mathbf{x}}_{ZF},\mu_m,\mathbf{R}_m)$ using Bayes' rule as:

$$c\Pr\left(\hat{\mathbf{x}}_{ZF}\big|x_m = s, \mu_m, \mathbf{R}_m\right) = c\exp\left(-\left(\hat{\mathbf{x}}_{ZF} - s\mathbf{e}_m - \mu_m\right)^H \mathbf{R}_m^{-1}\left(\hat{\mathbf{x}}_{ZF} - s\mathbf{e}_m - \mu_m\right)\right) \qquad \text{(Equation 5)}$$

where c is a scaling factor that disappears in the normalisation process. Hence we can compute the probability distribution function (PDF) for symbol m. When moving on to symbol m+1, the mean and auto-covariance of the equivalent noise $\mathbf{w}_{m+1}$ are re-computed using the new PDF of symbol m (from Equations 3 and 4). When the last symbol M is reached, the algorithm preferably goes back to the first one and repeats, for example for a predetermined number of iterations or until a convergence criterion is met.

At the start of the algorithm the probabilities are set to some initial value, for example, uniformly distributed or according to some *a priori* information, but as the decoding proceeds, these probabilities are updated. After a number of iterations, the output is given as the probabilities in $\Pr(x_m = s|\hat{\mathbf{x}}_{ZF}, \mu_m, \mathbf{R}_m)$.

Additionally or alternatively, if the probabilities of the individual bits making up a symbol are required, they can be computed as:

$$\Pr(b_q = 1) = \sum_{s|bit_q(s)=1} \Pr(x_m = s|\hat{\mathbf{x}}_{ZF}, \mu_m, \mathbf{R}_m) \qquad \text{(Equation 6)}$$

The procedure can be summarised as follows:

1. Compute the ZF estimate

$$\hat{x}_{ZF} = (H^H H)^{-1} H^H r = x + (H^H H)^{-1} H^H v$$

from **r** and **H**.

A MIMO channel estimate **H** can be obtained in a conventional manner using a training sequence. For example a training sequence can be transmitted from each transmit antenna in turn (to avoid interference problems), each time listening on all the receive antennas to characterise the channels from that transmit antenna to the receive antennas. This need not constitute a significant overhead and data rates are high in between training and, for example, with slowly changing indoor channels training may only be performed every, say, 0.1 seconds. Alternatively orthogonal sequences may be transmitted simultaneously from all the transmit antennas, although this increases the complexity of the training as interference problems can than arise.

2. Initialise symbol probabilities $\Pr(x_m, = s)$ using *a priori* information, for example from a channel decoder, or set them all equal if no such information is available.

3. Compute the expected values:

$$E\{x_m\} = \sum_{s \in S} s \Pr(x_m = s)$$

and variances:

$$Var\{x_m\} = \sum_{s \in S} |s - E\{x_m\}|^2 \Pr(x_m = s).$$

The expected values and variances are elements of $\mu_m$ and $\mathbf{R}_m$, respectively.

4. For symbol m=1, compute values of noise mean:

$$\mu_m = E\{\mathbf{w}_m\} = \sum_{k \neq m} E\{x_k\}\mathbf{e}_k$$

and auto-covariance:

$$\mathbf{R}_m = E\{(\mathbf{w}_m - \mu_m)(\mathbf{w}_m - \mu_m)^H\} = \sum_{k \neq m} E\{|x_k - E\{x_k\}|^2\}\mathbf{e}_k\mathbf{e}_k^H + \mathbf{R}_{\tilde{v}\tilde{v}}$$

A value for $\mathbf{R}_{\tilde{v}\tilde{v}}$ is obtained using $\mathbf{R}_{\tilde{v}\tilde{v}} = N_0(\mathbf{H}^H \mathbf{H})^{-1}$ value for $N_0$ may be estimated, optionally in conjunction with the channel estimate, in any convenient manner.

5. Compute the probabilities (for each symbol $s$ of constellation **S**):

$$\Pr\left(x_m = s \,\middle|\, \hat{\mathbf{x}}_{ZF}, \boldsymbol{\mu}_m, \mathbf{R}_m\right) = c\exp\left(-\left(\hat{\mathbf{x}}_{ZF} - s\mathbf{e}_m - \boldsymbol{\mu}_m\right)^H \mathbf{R}_m^{-1}\left(\hat{\mathbf{x}}_{ZF} - s\mathbf{e}_m - \boldsymbol{\mu}_m\right)\right)$$

where c is a scaling factor to make the sum of the values 1, (that is, to make them probabilities).

6. Update the expected values

$$E\{x_m\} = \sum_{s \in S} s\Pr\left(x_m = s\right)$$

and variances

$$Var\{x_m\} = \sum_{s \in S} \left|s - E\{x_m\}\right|^2 \Pr\left(x_m = s\right)$$

using the new probabilities.

7. Move onto the next symbols, i.e. $m \leftarrow m + 1$, and repeat steps 4-6.

When the last symbol has been processed, i.e., $m=M$, the process can start over again with $m = 1$ and steps 4-6 can be repeated again.

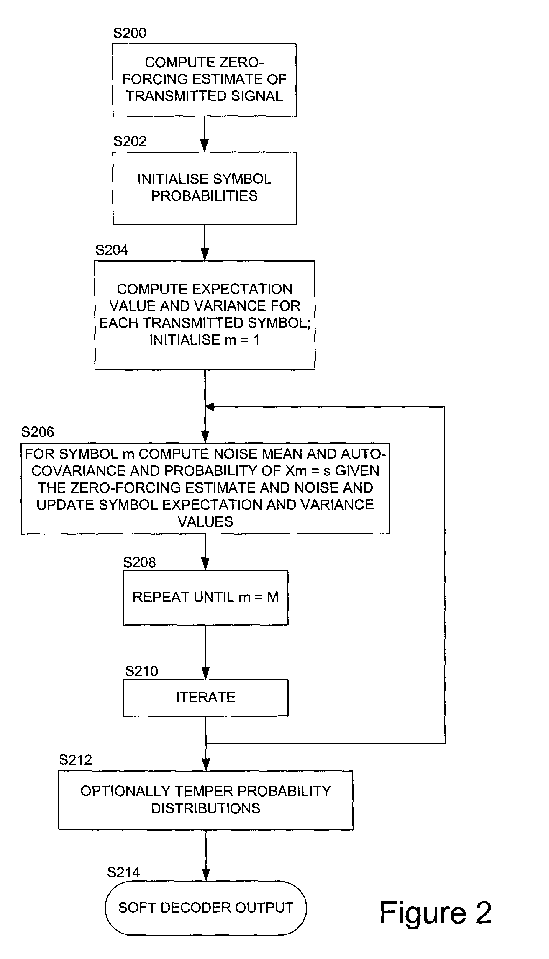

Figure 2 shows a flow diagram of the above procedure. Thus at step s200 an initial estimate of a transmitted string of symbols is determined, for example by calculating a zero-forcing estimate of the transmitted signal, and at step s202 the (transmitted) symbol probabilities are initialised, for example by setting these equiprobable. Then mean (expectation) and variance values are computed for each symbol of the processed string and the symbol counter m is initialised to point to the first symbol to be processed.

Then, at step s206, the procedure computes noise mean and auto-covariance values for symbol m and the probability of the transmitted symbol m having value s (for each possible s) given the zero forcing estimate and computered noise and the symbol expectation values and variances are then updated to take account of the new probabilities. Step s206 is repeated (s208) until m = $M$ where $M$ is the number of transmit antennas or, more generally, the number of symbols in the processed string, and preferably processing of the entire string of symbols is iterated (s210) for improved convergence of the calculated probabilities towards optimal values. Then optionally, at step s212, the bit/symbol probability distributions are tempered, as described further below, and the resulting bit/symbol probability values provide a (soft) output from the decoder (s214).

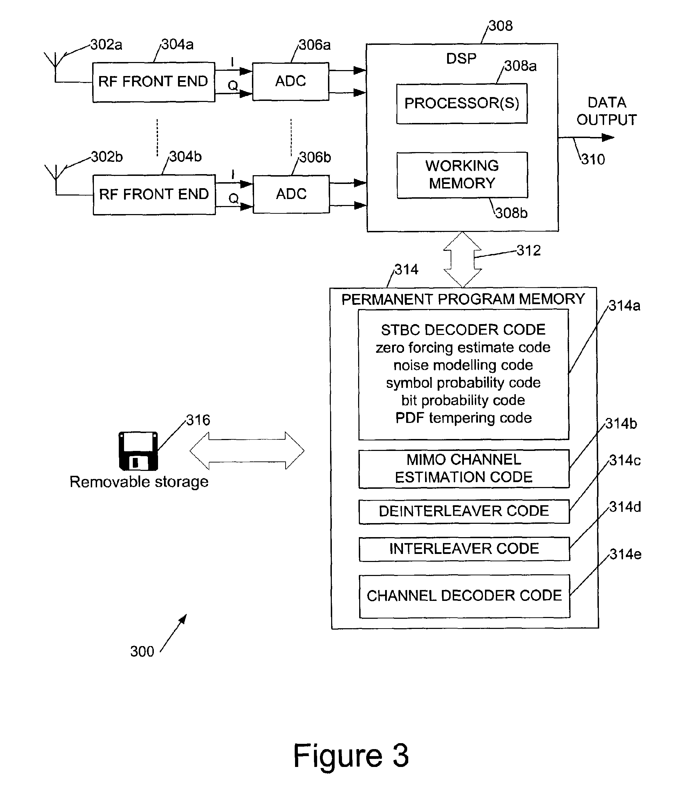

Figure 3 shows a receiver 300 incorporating a decoder configured to implement the above described method.

Receiver 300 comprises one or more receive antennas 302a, b (of which two are shown in the illustrated embodiment) each coupled to a respective rf front end 304a, b, for example similar to the rf front end of Figure 2a, and thence to a respective analogue-to-digital converter 306a,b and to a digital signal processor (DSP) 308. DSP 308 will typically include one or more processors 308a (for example, for a parallel implementation of filter 414) and some working memory 308b. The DSP 308 has a data output 310 and an address, data and control bus 312 to couple the DSP to permanent program memory 314 such as flash RAM or ROM. Permanent program memory 314 stores code and optionally data structures or data structure definitions for DSP 308.

As illustrated program memory 314 includes STBC decoder code 314a comprising zero forcing estimate code, noise modelling code, symbol probability code, bit probability code, arid PDF tempering code to, when running on DSP 308, implement corresponding functions as described above. Program memory 314 also includes MIMO channel estimation code 314b to provide a MIMO channel estimate **H**, de-interleaver code 314c, interleaver code 314d, and channel decoder code 314e. Examples of suitable code 314e are well known to those skilled in the art. Optionally the code in permanent program memory 314 may be provided on a carrier such as an optical or electrical signal carrier or, as illustrated in Figure 3, a floppy disk 316.

The data output 310 from DSP 308 is provided to further data processing elements of receiver 300 (not shown in Figure 3) as desired. These may a baseband data processor for implementing higher level protocols.

The receiver front-end will generally be implemented in hardware whilst the receiver processing will usually be implemented at least partially in software, although one or more ASICs and/or FPGAs may also be employed. The skilled person will recognise that all the functions of the receiver could be performed in hardware and that the exact point at which the signal is digitised in a software radio will generally depend upon a cost/complexity/power consumption trade-off.

Embodiments of the above MIMO decoder can offer near maximum likelihood performance at significantly reduced complexity.

A decoder based upon this technique may be used within a turbo decoding framework, in which case it is operated in a soft-in soft out (SISO) configuration. In such a configuration the decoder receives soft channel observations (continuous in value) and incorporates prior probabilities into the detection process (see, for example, step (2) in the summary of the operating procedure above). Furthermore the decoder also outputs a set of posterior probability values (soft out).

In practice the quality of the soft output from the proposed MIMO decoder can on occasions be poor. More specifically, the decoder sometimes (with high signal-to-noise ratio) produces over-confident results, allocating nearly all probability to a single proposition. This information is passed over to the channel decoder and, when incorrect, may destabilise the channel decoder, for example trapping the decoder in a incorrect solution. In some cases a single MIMO decoder error (over one bit) may cause an error after the decoder that, under other circumstances, would have been well within error correcting capabilities of the channel code.

This problem can be mitigated or overcome by modifying the MIMO decoder output. There are many possible ways of doing this and here we describe one example of a simple device that provides a solution to this problem, flattening or skewing sharply peaked probability distributions so that the most likely value is less strongly favoured over the other(s). We will term this a tempering device (TD).

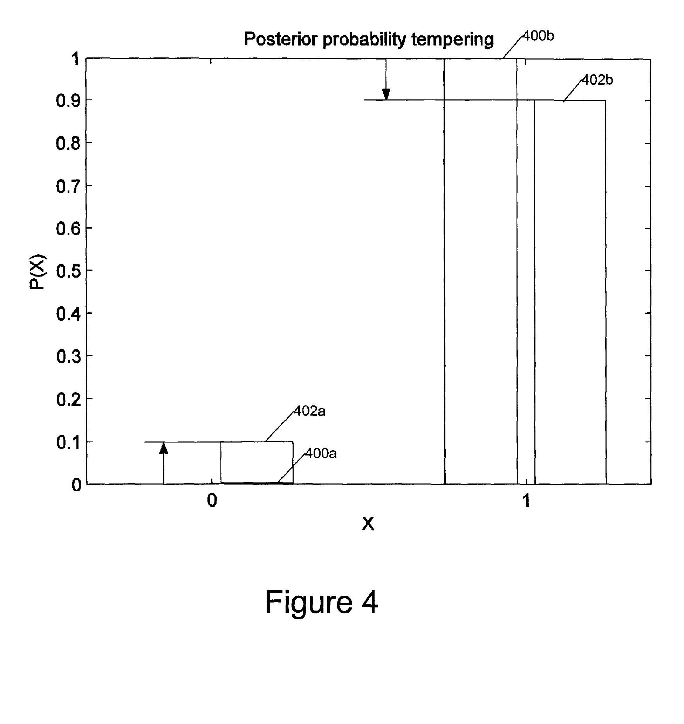

In this example, if the probability of a particular bit exceeds a threshold value, say 0.9, it is reduced to that value, otherwise it is kept as it is. Thus, to take an example, if $Pr(b_k = 1) = 0.99$, and consequently $Pr(b_k = 0) = 0.01$, the modified probabilities would be $Pr(b_k = 1) = 0.9$ and $Pr(b_k = 0) = 0.1$. This example is illustrated in Figure 4 in which bars 400a,b show the probabilities of a 0 and 1 respectively prior to tempering, and bars 402a,b show the probabilities after tempering. Thus the tempering operation skews the probability distribution of the bits as shown in the figure. The skilled person will appreciate that this MIMO decoder modification improves the performance of the decoder only when it is used in conjunction with a channel decoder (or other device for which an overly confident assignment of probability to an incorrect value could cause problems).

An equivalent way of looking at the tempering procedure is in terms of limiting values of the logarithm of the ratio of posterior probabilities $L_{APP}$. The tempering procedure expressed in such form is summarised below:

$$\text{If } SNR > SNR_{\text{limit}}$$

$$\text{If } LLR_{bi} = abs\left( \log\left( \frac{Pr(b_i = 0)}{Pr(b_i = 1)} \right) \right) > LLR_{\lim it}$$

$$\text{Do: } LLR_{bi} = sign(LLR_{bi}) * LLR_{\lim it}$$

where:
the log likelihood ratio of bit values 0 and 1 is defined by

$$\log\left( \frac{Pr(b_i = 0)}{Pr(b_i = 1)} \right);$$

$SNR_{\lim it}$ is a predefined SNR (signal-to-noise ratio) above which the algorithm is applied; and
$LLR_{\lim it}$ is a predefined $L_{APP}$ ratio.

The skilled person will appreciate that other probability distribution function tempering procedures are also possible. For example a procedure based upon simulated annealing may be employed in which a probability distribution function or one or more bit or symbol probabilities are randomly modified in accordance with a temperature which determines the degree of modification, the temperature being gradually reduced over time (turbo decoding iterations) with the aim of allowing the system to escape from local maxima/mimima and, in the end, more accurately decode the received signal.

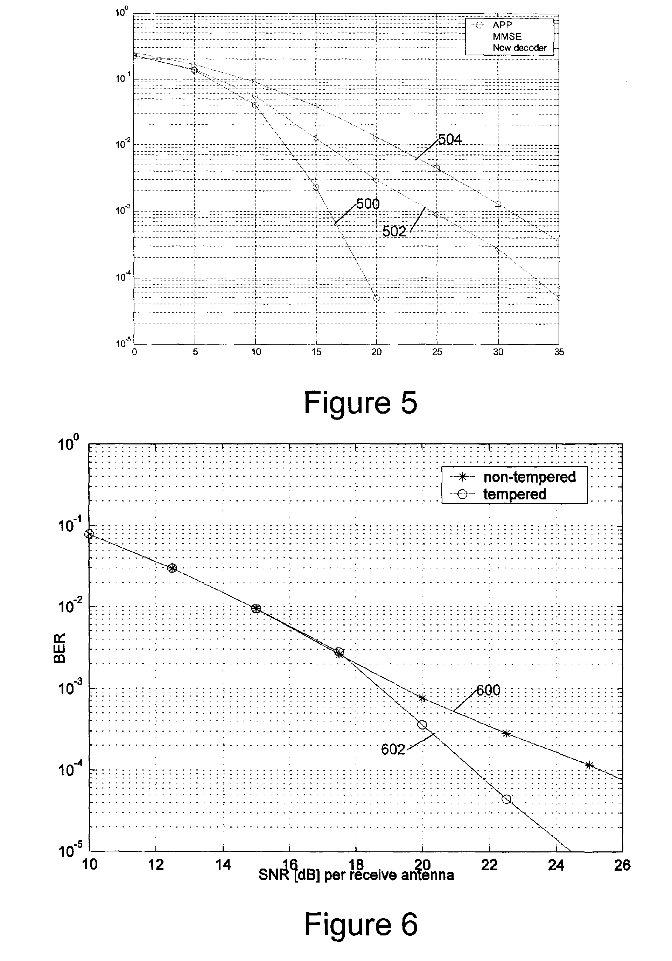

Figure 5 shows a graph of bit error rate against received signal to noise ratio (in dB) and presents results of a simulation of a system with four transmit antennas, four receive antennas and 16 QAM modulation. Curves for three decoders are compared, an optimal APP decoder (curve 500), a linear MMSE estimator (curve 502), and an embodiment of the above described decoder (curve 504) employing five iterations through each set of four received symbols. It can be seen that the above described decoder performs significantly better than the MMSE estimator (although less well than the APP decoder) but with a complexity which is comparable with the MMSE estimator and which is orders of magnitude less than that of the APP decoder. Thus it can be appreciated that embodiments of the decoder described herein offer a good performance/complexity trade-off.

Figure 6 shows a graph of bit error rate against signal-to-noise ratio (in dB) per receive antenna, showing an improvement in performance when applying tempering in a system which also employs channel coding. The results relate to a system with four transmit and four receive antennas, using 16-QAM modulation (with Gray mapping), and a rate ½ [5,7] RSC code. Curve 600 illustrates performance of the MIMO decoder without tempering and curve 602 illustrates the improved performance when tempering is applied, at a bit error rate of $10^{-4}$ this amounting to almost 4dB.

Embodiments of the invention have mainly been described with reference to space-time encoding/decoding but similar techniques may also be employed in the frequency domain, for example by serial-to-parallel converting and then performing a fast Fourier transform prior to MIMO decoding, applying an inverse Fourier transform and parallel-to-serial conversion after MIMO decoding.

The skilled person will appreciate that the above described techniques may be employed in any MIMO communications system, for example in base stations, access points, and/or mobile terminals. The techniques have applications in wireless LANs, potentially in fourth generation mobile phone networks, and also in many other types of communication system. Broadly speaking embodiments of the invention facilitate cheaper receivers with only a small loss of performance, or equivalently increased data rates without correspondingly increased complexity and cost. Embodiments of the invention may also potentially find application in other non-radio MIMO-like systems, for example a disk drive with multiple read heads and multiple data recording layers in effect acting as multiple transmitters.

No doubt many other effective alternatives will occur to the skilled person. It will be understood that the invention is not limited to the described embodiments and encompasses modifications apparent to those skilled in the art lying within the spirit and scope of the claims appended hereto.

## Claims

1. A method of decoding a signal encoded as a string of symbols over space and time and/or frequency, transmitted over a MIMO (multiple-input multiple-output) channel, and received at a plurality of receive antennas, each transmitted symbol having one of a plurality of values, said decoding comprising determining a probability distribution for each symbol of the transmitted string of symbols; the method comprising:

   determining an initial estimate of said transmitted string of symbols from said received signal using an estimate of a response of said MIMO channel; and
   determining from said initial estimate a probability distribution for each symbol of the transmitted string of symbols, the probability distribution representing the likelihood of a symbol of the string having each of its possible values when other symbols of the transmitted string are treated as noise.

2. A method as claimed in claim 1 further comprising initialising a probability distribution for each symbol of said transmitted string; and characterising said noise responsive to said initialised probability distributions; and wherein said determined symbol probability distributions represent the likelihood of a said symbol given said characterised noise.

3. A method as claimed in claim 2 wherein said characterising comprises determining mean and covariance values for said noise.

4. A method as claimed in claim 2 or 3 further comprising recharacterising said noise after determining a probability distribution for a symbol.

5. A method as claimed in any preceding claim further comprising redetermining a said probability distribution for each symbol of said transmitted string after said determining of a said probability distribution for each symbol from said initial estimate.

6. A method as claimed in claim 5 further comprising iterating said redetermining.

7. A method as claimed in any preceding claim further comprising adjusting a said symbol probability distribution or a probability distribution derived therefrom to increase the uncertainty in the value of a bit or symbol predicted by the adjusted distribution.

8. A method as claimed in claim 7 wherein said tempering comprises adjusting one or more probability distributions of one or more bits of said symbol.

9. A method of decoding a signal as claimed in any preceding claim wherein said signal is encoded using a space-time block code.

10. A method of turbo decoding of a signal comprising iteratively decoding said signal according to the method of any one of claims 1 to 9 and decoding a channel coding of the decoded signal.

11. Processor control code to, when running, implement the method of any preceding claim.

12. A carrier carrying the processor control code of claim 11.

13. A decoder for decoding a signal encoded as a string of symbols over space and time and/or frequency, transmitted over a MIMO (multiple-input multiple-output) channel, and received at a plurality of receive antennas, each transmitted symbol having one of a plurality of values, said decoding comprising determining a probability distribution for each symbol of the transmitted string of symbols, said decoder comprising:

   means for determining an initial estimate of said transmitted string of symbols from said received signal using an estimate of a response of said MIMO channel; and
   means for determining from said initial estimate a probability distribution for each symbol of the transmitted string of symbols, the probability distribution representing the likelihood of a symbol of the string having each of its possible values when other symbols of the transmitted string are treated as noise.

14. A receiver including the decoder of claim 13.

15. A space-time block decoder for decoding a string of transmitted symbols received over a MIMO channel, the decoder comprising:

   a symbol estimator to determine an initial estimate of said transmitted symbols;
   a noise modeller to determine a noise estimate for each transmitted symbol; and
   a probability distribution estimator to determine a probability distribution for each of said transmitted symbols; and wherein:

      said noise modeller is responsive to said symbol estimator;
      said probability distribution estimator is responsive to said noise estimator; and
      said noise estimator is responsive to said probability distribution estimator.

16. A space-time block decoder as claimed in claim 15 further composing:

   a probability adjuster to adjust an output of said probability distribution estimator to reduce a predicted probability.

17. A method of decoding a signal encoded as a string of symbols over space and time and/or frequency, transmitted over a MIMO (multiple-input multiple-output) channel, and received at a plurality of receive antennas, each transmitted symbol having one of a plurality of values, said decoding comprising determining a probability distribution for each symbol of the transmitted string of symbols; the method comprising:

   determining a probability distribution for each symbol of the transmitted string of symbols, the probability distribution representing the likelihood of a symbol of the string having each of its possible values; and tempering a said symbol probability distribution or a probability distribution derived therefrom to increase the uncertainty in the value of a symbol associated with the distribution.

**18.** A decoder configured to implement the method of claim 17.

Figure 1
(PRIOR ART)

S200

```
COMPUTE ZERO-
FORCING ESTIMATE OF
TRANSMITTED SIGNAL
```

S202

```
INITIALISE SYMBOL
PROBABILITIES
```

S204

```
COMPUTE EXPECTATION
VALUE AND VARIANCE FOR
EACH TRANSMITTED SYMBOL;
INITIALISE m = 1
```

S206

```
FOR SYMBOL m COMPUTE NOISE MEAN AND AUTO-
COVARIANCE AND PROBABILITY OF Xm = s GIVEN
THE ZERO-FORCING ESTIMATE AND NOISE AND
UPDATE SYMBOL EXPECTATION AND VARIANCE
VALUES
```

S208

```
REPEAT UNTIL m = M
```

S210

```
ITERATE
```

S212

```
OPTIONALLY TEMPER PROBABILITY
DISTRIBUTIONS
```

S214

```
SOFT DECODER OUTPUT
```

# Figure 2

302a  304a  306a  308

RF FRONT END — ADC

I
Q

DSP

308a

PROCESSOR(S)

DATA OUTPUT

310

302b  304b  306b

RF FRONT END — ADC

I
Q

WORKING MEMORY

308b

312

314

PERMANENT PROGRAM MEMORY

314a

STBC DECODER CODE
zero forcing estimate code
noise modelling code
symbol probability code
bit probability code
PDF tempering code

316

Removable storage

314b
314c

MIMO CHANNEL ESTIMATION CODE

DEINTERLEAVER CODE

314d

INTERLEAVER CODE

314e

CHANNEL DECODER CODE

300

Figure 3

Figure 4

Figure 5

Figure 6

## EUROPEAN SEARCH REPORT

**European Patent Office**

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | ZHI TIAN: "Soft decision feedback equalization for pre-coded FIR-MIMO systems" 2002 IEEE SENSOR ARRAY AND MULTICHANNEL SIGNAL PROCESSING WORKSHOP PROCEEDINGS, 4 August 2002 (2002-08-04), pages 594-598, XP010635820 * section 2 * | 1-6,9-15 | H04L1/06 H04L25/03 H04B7/06 |
| X,D | LUO J ET AL: "NEAR-OPTIMAL MULTIUSER DETECTION IN SYNCHRONOUS CDMA USING PROBABILISTIC DATA ASSOCIATION" IEEE COMMUNICATIONS LETTERS, PISCATAWAY,US, vol. 5, no. 9, September 2001 (2001-09), pages 361-363, XP001107968 ISSN: 1089-7798 * section II * | 1-6,9-15 | |
| X | PHAM D ET AL: "A PDA-Kalman approach to multiuser detection in asynchronous CDMA" IEEE COMMUNICATIONS LETTERS, IEEE, USA, vol. 6, no. 11, November 2002 (2002-11), pages 475-477, XP002316889 ISSN: 1089-7798 * section II * | 1-6,9-15 | TECHNICAL FIELDS SEARCHED (Int.Cl.7) H04L H04B |
| P,X | PHAM D ET AL: "A generalized probabilistic data association detector for multiple antenna systems ˜" COMMUNICATIONS, 2004 IEEE INTERNATIONAL CONFERENCE ON PARIS, FRANCE 20-24 JUNE 2004, PISCATAWAY, NJ, USA,IEEE, vol. 6, 20 June 2004 (2004-06-20), pages 3519-3522, XP010712361 ISBN: 0-7803-8533-0 * section III * | 1-6,9-15 | |

-/--

The present search report has been drawn up for all claims

| Place of search | Date of completion of the search | Examiner |
|---|---|---|
| The Hague | 9 February 2005 | Ghigliotti, L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

**EUROPEAN SEARCH REPORT**

Application Number

EP 04 25 4557

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| P,X | SHOUMIN LIU ET AL: "A soft-decision approach for BLAST systems with less receive than transmit antennae" GLOBECOM'03. 2003 - IEEE GLOBAL TELECOMMUNICATIONS CONFERENCE. CONFERENCE PROCEEDINGS. SAN FRANCISCO, DEC. 1 - 5, 2003, IEEE, NEW YORK, NY, US, vol. 7 OF 7, 1 December 2003 (2003-12-01), pages 834-838, XP010678182 ISBN: 0-7803-7974-8 * section III-A * | 1-6,9-15 | |
| P,X | SHOUMIN LIU ET AL: "A cross-layer Kalman-PDA approach to soft-decision equalization for FIR MIMO channels" WIRELESS COMMUNICATIONS AND NETWORKING CONFERENCE, 2004. WCNC. 2004 IEEE ATLANTA, GA, USA 21-25 MARCH 2004, IEEE, PISCATAWAY, NJ, USA, vol. 4, 21 March 2004 (2004-03-21), pages 2307-2312, XP010708319 ISBN: 0-7803-8344-3 * sections III-A, III-B(3) * | 1-6,9-15 | |
| P,X | LIU S ET AL: "NEAR-OPTIMUM SOFT DECISION EQUALIZATION FOR FREQUENCY SELECTIVE MIMO CHANNELS" IEEE TRANSACTIONS ON SIGNAL PROCESSING, IEEE, INC. NEW YORK, US, vol. 52, no. 3, March 2004 (2004-03), pages 721-733, XP001198494 ISSN: 1053-587X * section III-A * | 1-6,9-15 | TECHNICAL FIELDS SEARCHED (Int.Cl.7) |

The present search report has been drawn up for all claims

| Place of search | Date of completion of the search | Examiner |
|---|---|---|
| The Hague | 9 February 2005 | Ghigliotti, L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

...............................................................................................

& : member of the same patent family, corresponding document

EPO FORM 1503 03.82 (P04C01)